(19) Europäisches Patentamt
European Patent Office
Office européen des brevets

(11) **EP 1 269 707 B1**

(12) **FASCICULE DE BREVET EUROPEEN**

(45) Date de publication et mention
de la délivrance du brevet:
**03.01.2007 Bulletin 2007/01**

(21) Numéro de dépôt: **01919590.8**

(22) Date de dépôt: **28.03.2001**

(51) Int Cl.:
**H04L 27/36** $^{(2006.01)}$

(86) Numéro de dépôt international:
**PCT/FR2001/000940**

(87) Numéro de publication internationale:
**WO 2001/076169 (11.10.2001 Gazette 2001/41)**

(54) **DISPOSITIF DE PRODUCTION D'UN SIGNAL RADIOFREQUENCE MODULE EN PHASE ET EN AMPLITUDE**

VORRICHTUNG ZUR ERZEUGUNG EINES PHASEN- UND AMPLITUDENMODULIERTEN HOCHFREQUENZSIGNALS

DEVICE FOR PRODUCING A PHASE AND AMPLITUDE MODULATED RADIO FREQUENCY SIGNAL

(84) Etats contractants désignés:
**AT BE CH CY DE DK ES FI FR GB GR IE IT LI LU MC NL PT SE TR**

(30) Priorité: **31.03.2000 FR 0004124**

(43) Date de publication de la demande:
**02.01.2003 Bulletin 2003/01**

(73) Titulaire: **EADS Secure Networks**
**78180 Montigny le Bretonneux (FR)**

(72) Inventeurs:
- **GAGEY, Olivier**
  **F-75006 Paris (FR)**
- **MOLKO, Christophe**
  **F-92150 Suresnes (FR)**
- **BELVEZE, Fabrice**
  **F-78310 Maurepas (FR)**

(74) Mandataire: **Verdure, Stéphane**
**Cabinet Plasseraud**
**52 rue de la Victoire**
**75440 Paris Cedex 09 (FR)**

(56) Documents cités:
**US-A- 3 619 503**

- **MANN S. ET AL.: "INCREASING TALK-TIME WITH EFFICIENT LINEAR PA'S" IEE SEMINAR ON TETRA MARKET AND TECHNOLOGY DEVELOPMENTS, 10 février 2000 (2000-02-10), pages 6/1-6/7, XP002155349 LONDRES, ROYAUME-UNI**
- **LIU W. ET AL.: "CONSIDERATIONS ON APPLYING OFDM IN A HIGHLY EFFICIENT POWER AMPLIFIER" IEEE TRANSACTIONS ON CIRCUITS AND SYSTEMS- II, ANALOG AND DIGITAL SIGNAL PROCESSING, vol. 46, no. 11, novembre 1999 (1999-11), pages 1329-1336, XP002155350 PISCATAWAY, ¹TATS-UNIS**
- **WU J -T ET AL: "TP 5.2: A 2V 100MHZ CMOS VECTOR MODULATOR" IEEE INTERNATIONAL SOLID STATE CIRCUITS CONFERENCE, vol. 40, février 1997 (1997-02), pages 80-81,434, XP000753022 NEW YORK, ¹TATS-UNIS ISSN: 0193-6530**

## Description

La présente invention concerne un dispositif de production d'un signal radiofréquence modulé en phase et en amplitude convenant pour l'émission radioélectrique via une antenne.

Un tel dispositif trouve des applications dans des émetteurs radiofréquences, notamment de stations mobiles de radiocommunication.

Les systèmes de radiocommunication actuels utilisent classiquement, pour la transmission de données numériques codant un signal audio ou, plus généralement, des informations de toute nature, des modulations dites à enveloppe constante. Avec de telles modulations, les données émises ne sont pas portées par l'amplitude d'une porteuse radiofréquence mais par sa phase ou sa fréquence. Ceci permet d'utiliser dans l'émetteur un amplificateur de puissance radiofréquence fonctionnant dans une zone de fonctionnement proche de la saturation. Ainsi, l'émetteur présente un rendement en puissance élevé, ce qui est particulièrement requis dans le cadre d'une utilisation de l'émetteur dans un équipement de radiocommunication portatif. En effet, comme on le sait, l'émetteur présente dans une telle zone de fonctionnement des non-linéarités d'amplification comprenant des non linéarités en amplitude et, dans une moindre mesure, des non linéarités en phase. Ces non-linéarités engendrent une distorsion en amplitude et en phase du signal émis, qui dégradent les performances de l'émetteur en termes de qualité de l'émission. C'est pour s'affranchir du problème des non-linéarités d'amplitude qu'on n'utilise dans les systèmes de radiocommunication actuels que des modulations à enveloppe constante. En effet, l'information utile n'étant pas portée par l'amplitude du signal radiofréquence émis, les non-linéarités d'amplitude n'affectent pas la qualité de l'émission.

Toutefois, on cherche actuellement à transmettre plus d'informations à l'intérieur d'une bande de fréquence de largeur donnée, affectée à un canal de transmission, de manière à augmenter le rendement spectral des systèmes de radiocommunication. Le but est de répondre à l'accroissement de la demande de trafic dans le spectre radiofréquence en respectant les contraintes liées au partage de ce spectre. C'est pourquoi on envisage la réintroduction d'une modulation d'amplitude. Ainsi, on cherche à mettre au point de nouveaux systèmes de radiocommunication utilisant pour la transmission des informations une modulation composite, comportant à la fois une composante de modulation de phase et une composante de modulation d'amplitude.

Malgré cela, la nécessité de maintenir un rendement en puissance important de l'émetteur, incite à continuer de faire fonctionner l'amplificateur de puissance radiofréquence dans une zone de fonctionnement proche de la saturation. Il est donc souhaitable d'annuler les effets des non-linéarités d'amplification induites par l'amplificateur de puissance radiofréquence, afin de ne pas dégrader la qualité de l'émission.

Plusieurs techniques sont connues pour annuler les effets des non-linéarités d'amplification. Dans la technique CLLT (de l'anglais "Cartesian Loop Linear Transmitter"), un démodulateur est utilisé pour asservir, en bande de base et en analogique, la modulation du signal présent au niveau de l'antenne avec celle du signal en bande de base à émettre. Dans la technique ABP (de l'anglais "Adaptative Baseband Predistortion"), un traitement numérique appliqué aux échantillons du signal en bande de base à émettre permet de pré-distordre ce signal pour obtenir le signal radiofréquence souhaité au niveau de l'antenne. Toutefois, la mise en oeuvre de ces techniques connues dans le cadre d'une modulation composite est complexe et impose de modifier en profondeur l'architecture des émetteurs actuels.

C'est pourquoi, la présente invention propose un dispositif de production d'un signal radiofréquence modulé en phase et en amplitude reposant sur une technique connue sous le nom de technique EER (de l'anglais "Envelope Elimination and Restoration"). L'article de Mann et al. "Increasing Talk-Time With Efficient Linear PA'S", IEEE Seminar on Tetra Market and Technology Developments, 10 February 2000, pages 6/1 - 6/7, et l'article de Liu et al. " Considerations on Applying OFDM in a highly Efficient Power Amplifier", IEEE Transactions on Circuits and Systems-II, Analog and Digital Signal Processing, vol. 46, no. 11, novembre 1999, pages 1329 - 1336, décrivent des émetteurs fonctionnants selon la technique EER. Selon cette technique, le dispositif comprend des moyens de codage composite permettant de générer à partir des données à émettre une première suite de valeurs numériques correspondant à une composante de modulation de phase du signal de sortie G et une seconde suite de valeurs numériques correspondant à une composante de modulation d'amplitude de ce signal. Ces deux composantes sont ensuite transposées dans le domaine radiofréquence par des moyens distincts. Les composantes ainsi transposées sont ensuite combinées pour former le signal de sortie G. Dit autrement, la technique EER ne respecte pas le schéma classique consistant à générer un signal en bande de base modulé en phase et en amplitude puis à transposer ce signal dans le domaine radiofréquence. Cette technique est avantageuse car elle permet de conserver une architecture de l'émetteur proche de celle utilisée dans le cadre des systèmes actuels utilisant une modulation à enveloppe constante.

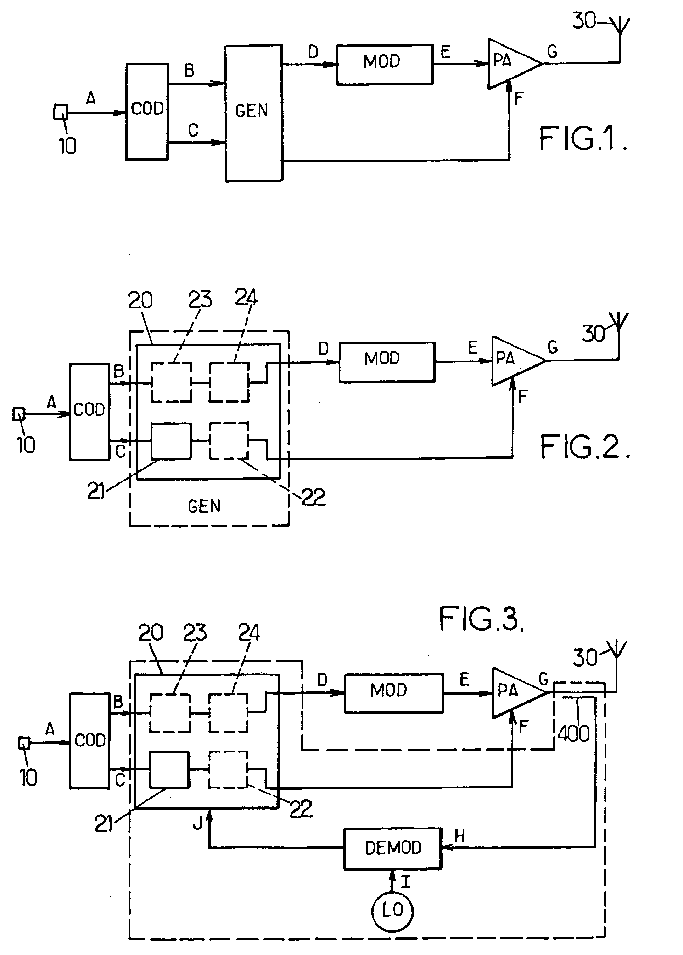

Le schéma de la figure 1 donne une illustration d'un dispositif de génération d'un signal radiofréquence modulé en phase et en amplitude reposant sur la technique EER. Le dispositif comprend au moins une entrée de données 10 pour recevoir un message numérique A contenant des données à transmettre. Il comprend en outre des moyens de codage composites tels qu'un codeur COD pour générer, à partir dudit message numérique A, une première suite de valeurs numériques B et une seconde suite de valeurs numériques C. La suite B correspond à une composante de modulation de phase du signal de sortie G du dispositif. La suite C correspond à une composante de modulation d'amplitude du signal de sortie G. Le dispositif comprend encore des moyens de génération d'un signal de commande de phase D et d'un signal de commande d'amplitude F à partir de la première suite de valeurs numériques B et de la seconde suite de valeurs numériques C. Les signaux D et F sont par exemple des signaux analogiques délivrés par des convertisseurs numériques analogiques (non représentés) des moyens de génération GEN. Les valeurs numériques de la première suite B et de la seconde suite C sont traitées comme des échantillons des signaux de commande respectivement de phase D et d'amplitude F.

Le dispositif comprend encore des moyens de modulation de phase MOD dont une entrée reçoit le signal de commande de phase D et dont une sortie délivre un signal radiofréquence E d'amplitude sensiblement constante modulé en phase, en fonction du signal de commande de phase D. Le dispositif comporte enfin un amplificateur de puissance radiofréquence à gain variable PA, dont l'entrée est couplée à la sortie des moyens de modulation de phase MOD pour recevoir le signal radiofréquence E, dont une entrée de commande de gain reçoit le signal de commande d'amplitude F, et dont une sortie délivre un signal radiofréquence modulé en phase et en amplitude. Le signal G est le signal de sortie du dispositif. Ce signal convient pour l'émission radioélectrique via une antenne. Ainsi, la sortie de l'amplificateur PA peut être couplée à une antenne 30 pour l'émission radioélectrique du signal G.

Du fait que la composante de modulation de phase et la composante de modulation d'amplitude sont transposées de la bande de base vers le domaine radiofréquence par des moyens distincts, à savoir respectivement par les moyens de modulation MOD et par l'amplificateur de puissance radiofréquence à gain variable PA, la composante de modulation de phase et la composante de modulation d'amplitude empruntent des chemins différents avant d'être combinées dans le signal de sortie G. Or, selon le type codage utilisé, il est nécessaire que la composante de modulation de phase soit synchronisée avec la composante de modulation d'amplitude dans le signal émis, afin de permettre un décodage correct côté récepteur et une pureté spectrale satisfaisante en émission. Il est donc souhaitable de compenser les différences de temps de transmission de ces deux composantes sur leurs chemins respectifs.

Ce but est atteint conformément à l'invention grâce à un dispositif de production d'un signal de sortie radiofréquence modulé en phase et en amplitude convenant pour l'émission radioélectrique selon la revendication 1.

Les moyens de calage de la revendication 1 comprennent préférentiellement au moins des premiers moyens numériques pour appliquer un premier retard à la première suite de valeurs numériques ou à la seconde suite de valeurs numériques, de manière que la composante de modulation de phase soit synchronisée avec la composante de modulation d'amplitude dans le signal de sortie. Une telle solution numérique présente l'avantage de permettre une bonne intégration du dispositif.

Pour obtenir un rendement en puissance élevé, l'amplificateur de puissance radiofréquence est préférentiellement agencé pour fonctionner dans une zone de fonctionnement proche de la saturation. C'est pourquoi l'invention propose des modes de réalisation permettant d'annuler les effets des non-linéarités d'amplitude et/ou de phase introduites dans l'amplificateur.

Dans certaines applications, le niveau de puissance moyen du signal de sortie G peut varier par paliers, en fonction du mode de fonctionnement de l'émetteur incorporant le dispositif. Les paliers du niveau de puissance moyen sont commandés par la valeur de la composante continue du signal de commande d'amplitude F appliquée sur l'entrée de commande de gain de l'amplificateur de puissance, la composante alternative de ce signal constituant la consigne de modulation d'amplitude. L'invention propose un mode de réalisation permettant dans ce cas de limiter la charge de calcul du DSP et d'éviter la nécessité d'un convertisseur numérique/analogique de résolution élevée. Dans ce mode de réalisation, un signal analogique de commande du palier de puissance et un signal analogique de commande de la modulation d'amplitude sont générés séparément et sont additionnés de manière analogique avant d'être appliqués sur l'entrée de commande de gain de l'amplificateur à gain variable.

L'invention propose en outre des modes de réalisation dans lesquels un amplificateur à gain variable correctement agencé permet de s'affranchir du problème de la variation, avec la valeur du niveau moyen de puissance du signal radiofréquence à émettre, de la réponse d'un détecteur faisant partie de moyens analogiques d'asservissement de l'amplitude du signal de sortie à une consigne de modulation d'amplitude.

D'autres caractéristiques et avantages de l'invention apparaîtront à la lecture de la description qui va suivre. Celle-ci est purement illustrative et doit être lue en regard des dessins annexés sur lesquels on a représenté :

- à la figure 1, déjà analysée : le schéma du principe d'un dispositif de production d'un signal radiofréquence modulé en phase et en amplitude reposant sur la technique EER ;
- à la figure 2 : le schéma d'un premier mode de réalisation d'un dispositif selon l'invention ;
- à la figure 3 : le schéma d'un deuxième mode de réalisation d'un dispositif selon l'invention ;
- à la figure 4 : le schéma d'un troisième mode de réalisation d'un dispositif selon l'invention ;
- à la figure 5 : le schéma d'un quatrième mode de réalisation d'un dispositif selon l'invention ;
- à la figure 6 : le schéma d'un cinquième mode de réalisation d'un dispositif selon l'invention ;
- à la figure 7 : le schéma d'un sixième mode de réalisation d'un dispositif selon l'invention ;
- à la figure 8 : le schéma d'un septième mode de réalisation d'un dispositif selon l'invention ;

- à la figure 9 : le schéma partiel d'un huitième mode de réalisation d'un dispositif selon l'invention ;
- à la figure 10 : le schéma partiel d'un neuvième mode de réalisation d'un dispositif selon l'invention ;
- à la figure 11 : le schéma d'un dixième mode de réalisation d'un dispositif selon l'invention ;
- à la figure 12 : le schéma partiel d'un onzième mode de réalisation d'un dispositif selon l'invention;
- à la figure 13 : le schéma partiel d'un douzième mode de réalisation d'un dispositif selon l'invention ;
- à la figure 14 : le schéma partiel d'un treizième mode de réalisation d'un dispositif selon l'invention ;
- à la figure 15 : un graphique montrant la caractéristique entrée / sortie d'un détecteur faisant partie de moyens analogiques d'asservissement de l'amplitude du signal de sortie du dispositif selon l'invention.

L'invention propose plusieurs modes de réalisation d'un dispositif de production d'un signal G radiofréquence modulé en phase et en amplitude convenant pour l'émission radioélectrique via une antenne d'émission 30, qui reposent tous sur la technique EER tel que présentée en introduction en référence à la figure 1. Sur les figures et dans la suite, les mêmes éléments portent les mêmes références. Dans la suite, le signal radiofréquence à émettre G est aussi appelé signal de sortie du dispositif.

Dans tous les modes de réalisation présentés, les moyens de génération GEN ont pour fonction de produire le signal de commande de phase D et le signal de commande d'amplitude F appliqué respectivement en entrée des moyens de modulation de phase MOD et de l'amplificateur de puissance à gain variable PA. Pour un amplificateur PA réalisé en technologie MOS, le signal de commande d'amplitude F détermine par exemple une tension de grille, une tension de drain ou une puissance d'entrée. Pour un amplificateur PA réalisé en technologie bipolaire, le signal de commande d'amplitude F détermine par exemple une tension de base, une tension de collecteur ou une puissance d'entrée. Classiquement, le signal F est un signal analogique. Il présente une composante alternative traduisant la modulation d'amplitude et une composante continue qui peut être nulle. Dans certaines applications, le niveau de puissance moyen du signal de sortie G varie par paliers en fonction des modes de fonctionnement de l'émetteur incorporant le dispositif. Dans ce cas, le niveau de puissance moyen peut être commandé par la valeur de la composante continue du signal de commande F.

Les moyens de modulation de phase MOD sont par exemple constitués par un oscillateur à boucle verrouillée en phase (oscillateur dit à PLL, de l'anglais "Phase Locked Loop"). Dans ce cas, le signal D est un signal analogique. Néanmoins, les moyens de modulation de phase MOD comprennent préférentiellement un synthétiseur de modulation numérique (circuit DMS, de l'anglais "Digital Modulation Synthetizer"). Dans ce cas, le signal D est un signal numérique. Cette variante est avantageuse car un circuit DMS permet une meilleure intégration du dispositif. En effet, un oscillateur à PLL comprend des éléments analogiques qui occupent beaucoup de place, en comparaison du faible encombrement d'un circuit DMS. En tant que de besoin, les moyens GEN comprennent un ou plusieurs convertisseurs numérique/analogique (non représentés), pour passer des messages numériques composés des suites de valeurs numériques B et/ou C à des signaux analogiques ad-hoc respectivement D et/ou F.

Dans le mode de réalisation de la figure 2, les moyens de génération GEN du dispositif comprennent des moyens de calage temporel du signal de commande de phase D et du signal de commande d'amplitude F de manière que la composante de modulation de phase soit synchronisée avec la composante de modulation d'amplitude dans le signal de sortie G.

Ces moyens de calage temporel comprennent de préférence des premiers moyens numériques 20 pour appliquer un premier retard T1 à la première suite de valeurs numériques B ou à la seconde suite de valeurs numériques C. De tels moyens numériques sont avantageusement inclus dans un processeur de signal numérique (circuit DSP, de l'anglais "Digital Signal Processor") qui réalisent toutes les fonctions numériques des moyens de génération GEN. En général, le retard T1 est appliqué à la seconde suite de valeurs numériques C, car le temps de propagation sur le chemin emprunté par la composante de modulation d'amplitude est inférieur au temps de propagation sur le chemin emprunté par la composante de modulation de phase. Toutefois, cela n'est pas nécessairement le cas dans toutes les applications. De tels moyens numériques comprennent par exemple un registre à décalage 21 et/ou un filtre retardateur 22 par lequel ou par lesquels transitent la suite de valeurs numériques C à retarder. Un registre à décalage permet d'introduire un retard égal à un nombre entier de fois la période d'un signal d'horloge rythmant l'activité des convertisseurs numérique/analogique concernés. Il ne permet d'obtenir que des valeurs de retard ayant des valeurs discrètes, avec une résolution égale à cette période. Un filtre retardateur numérique permet au contraire d'appliquer un retard égal à une fraction de cette période. C'est pourquoi il peut être avantageux de les combiner pour appliquer un retard T1 de valeur quelconque.

Le filtre numérique présente préférentiellement, au moins dans la bande occupée par le message codé, une réponse constante en amplitude et une réponse linéaire en phase, la pente de cette dernière déterminant la valeur du retard introduit par le filtre. Il s'agit par exemple d'un filtre retardateur d'une valeur $\tau$ en sinus cardinal échantillonné et tronqué, dont la réponse impulsionnelle $f_\tau(t)$ est donnée par la relation (1) ci-dessous :

$$f_\tau(t) = \frac{\sin(\pi(t-\tau)/Te)}{\pi(t-\tau)/Te} \qquad (1)$$

où $1/Te$ est le débit des valeurs numériques dans le message numérique A.

Préférentiellement le filtre numérique est une version numérique du sinus cardinal, dont la réponse impulsionnelle $f_\tau(t)$ est donnée par la relation (2) ci-dessous :

$$f_\tau(t) = \frac{\sin(\pi(t-\tau)/Te)}{N\sin(\pi(t-\tau)/NTe)} \qquad (2)$$

où $1/Te$ est le débit des valeurs numériques dans le message numérique A et où $N$ est un nombre entier, appelé longueur du filtre, qui correspond au nombre de valeurs numériques successives traitées simultanément par le filtre. Un tel filtre introduit un retard dont la valeur est égale à la moitié de la longueur du filtre plus un petit retard additionnel, positif ou négatif, qui vaut une fraction du temps $Te$ soit $\tau$.

Dans certains cas, il est préférable de prévoir en outre des seconds moyens numériques, tels qu'un registre à décalage 23 et/ou un filtre numérique retardateur 24 pour appliquer un second retard T2, différent du retard T1, à l'autre suite de valeurs numériques B. Dans ce cas, le retard équivalent appliqué à la seconde suite de valeurs numériques C par rapport à la première suite de valeurs numériques B est égal à T1-T2. Ceci permet d'appliquer un retard équivalent de valeur plus fine.

Dans le mode de réalisation de la figure 2, le retard appliqué est déterminé une fois pour toutes lors d'une phase de calibration qui peut être réalisée en laboratoire. En général, il est alors le même pour tous les exemplaires du dispositif qui sont fabriqués.

Dans un autre mode de réalisation conforme à la figure 3, les moyens de calage temporel sont agencés pour réaliser un calage temporel du signal de commande de phase D et du signal de commande d'amplitude F en fonction d'un signal en bande de base J obtenu à partir du signal de sortie G.

A cet effet, le dispositif comprend des moyens formant voie de retour en bande de base, pour produire un signal en bande de base J correspondant au signal de sortie G. Ces moyens comprennent un dispositif de couplage 400 qui prélève en sortie de l'amplificateur de puissance PA une partie de la puissance du signal de sortie G, et délivre un signal H qui est l'image, en termes de modulation de phase et d'amplitude, du signal de sortie G. En outre, ils comprennent des moyens de démodulation DEMOD qui reçoivent sur une entrée le signal H et délivrent sur une sortie ledit signal en bande de base J. Les moyens de démodulation DEMOD reçoivent en outre un signal radiofréquence I de même fréquence que la fréquence porteuse, qui est mélangé au signal H pour assurer le retour en bande de base de ce signal. Ce signal I est par exemple délivré par un oscillateur local LO. Le signal en bande de base J et le signal en bande de base à transmettre sont très proches. Ils ne diffèrent que par l'effet des imperfections du calage des signaux de commande de phase D et d'amplitude F, et par l'effet des non linéarités d'amplification introduites dans le signal de sortie G par l'amplificateur de puissance radiofréquence PA. Le signal J est échantillonné et converti en données numériques au moyen d'un convertisseur analogique/numérique (non représenté) des moyens de génération GEN. Ces valeurs numériques sont prises en compte pour le réglage du retard appliqué par les moyens de calage temporel. Dans un exemple, on fait varier la longueur N du filtre numérique 22 ou 24 donné par la relation (2) ci-dessus. Egalement, il est possible de déplacer un pointeur de lecture dans le registre à décalage 21 ou 23 ce qui revient à faire varier sa longueur.

En variante, le signal I peut être remplacé par le signal E, qui est le signal d'amplitude sensiblement constante modulé en phase délivré en sortie des moyens de modulation MOD. Dans ce cas, le signal en bande de base J est représentatif des imperfections du calage des signaux de commande de phase D et d'amplitude F, et de l'effet des non linéarités d'amplification introduites dans le signal de sortie G par l'amplificateur de puissance radiofréquence PA.

Ce mode de réalisation permet de réaliser un asservissement du calage temporel des signaux de commande de phase D et d'amplitude F en fonction du signal de sortie G. Le retard à appliquer par les moyens de calage temporel 20 est déterminé en fonction des valeurs numériques obtenues à partir du signal J. De cette manière, le calage temporel des signaux D et F tient compte notamment de l'éventuelle dispersion des caractéristiques des composants analogiques constituant le dispositif (qui sont présents essentiellement dans l'amplificateur PA), de la dérive en température et des effets du vieillissement sur la valeur de ces composants.

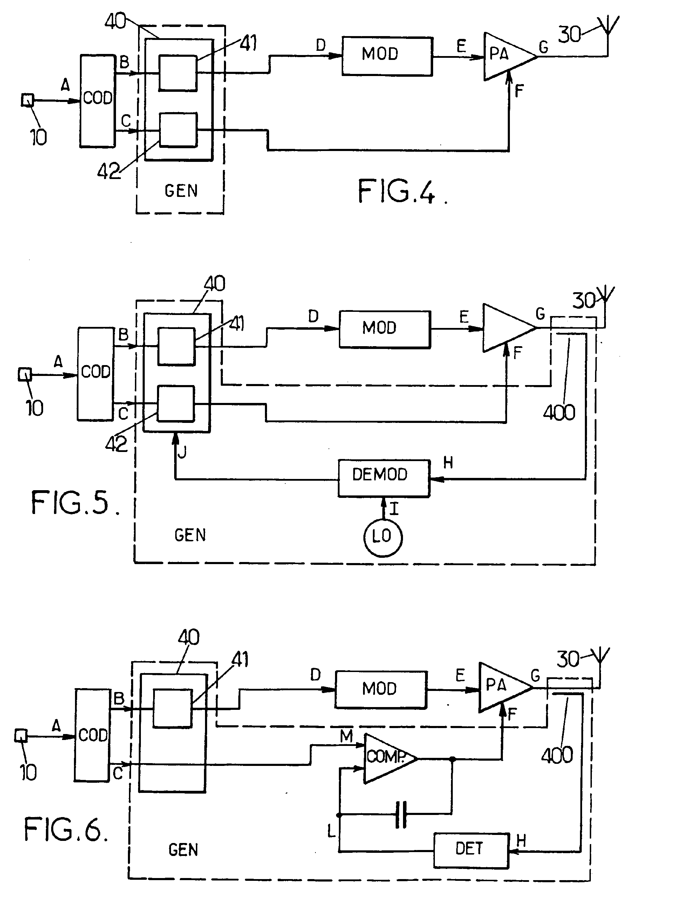

Dans un autre mode de réalisation conforme à la figure 4, les moyens de génération GEN comprennent des moyens numériques de pré-distorsion 40, incluant des moyens de pré-distorsion en phase 41 et/ou des moyens de pré-distorsion en amplitude 42. Ces moyens permettent d'annuler l'effet des non linéarités d'amplification (respectivement en phase et/ou en amplitude).

Les moyens de pré-distorsion en phase 41 comportent une première table de valeurs associant une valeur numérique pré-distordue à chaque valeur numérique de la première suite de valeurs numériques B. Dit autrement, chaque valeur numérique de la suite B est remplacée dans ladite suite par une valeur numérique de la première table de pré-distorsion qui lui est associée. De la sorte, le signal de commande de phase D est généré en fonction de la suite desdites valeurs numériques pré-distordues de manière à annuler l'effet des non-linéarités en phase introduites dans le signal de sortie G par l'amplificateur PA. Les moyens de pré-distorsion en amplitude 42 comportant une seconde table de valeurs associant une valeur numérique pré-distordue à chaque valeur numérique de la seconde suite de valeurs numériques C. Dit autrement, chaque valeur numérique de la suite C est remplacée dans ladite suite par une valeur numérique de la seconde table de pré-distorsion qui lui est associée. De cette manière, le signal de commande d'amplitude F est généré en fonction de la suite desdites valeurs numériques pré-distordues, ce qui permet d'annuler l'effet des non-linéarités en amplitude introduites dans le signal de sortie G par l'amplificateur PA.

Dans le mode de réalisation de la figure 4, les valeurs de la première et/ou de la seconde tables de pré-distorsion sont déterminées lors d'une phase de calibration qui peut être réalisée en laboratoire. Elles sont donc constantes pendant toute la vie de l'équipement de radiocommunication. En général, elles sont identiques pour tous les exemplaires du dispositif qui sont fabriqués.

Dans un autre mode de réalisation conforme à la figure 5, les moyens de pré-distorsion 40, c'est à dire les moyens de pré-distorsion en phase 41 et/ou les moyens de pré-distorsion en amplitude 42, sont agencés pour réaliser une pré-distorsion en fonction d'un signal en bande de base J obtenu à partir du signal de sortie G. Dit autrement, les moyens 41 réalisent une pré distorsion adaptative en phase des valeurs numériques de la suite B, et/ou les moyens 42 réalisent une pré-distorsion adaptative en amplitude des valeurs numériques de la suite C. On parle de pré-distorsion adaptative, dans la mesure où elle prend en compte, de manière continue, les distorsions d'amplification réelles introduites par l'amplificateur PA dans le signal de sortie G.

A cet effet, le dispositif comprend les moyens précités formant voie de retour en bande de base, c'est à dire le dispositif de couplage 400, les moyens de démodulation DEMOD, et le cas échéant l'oscillateur local LO qui ont été présentés ci-dessus en référence au mode de réalisation de la figure 3, le signal en bande de base J étant fourni en entrée des moyens 40. Bien que ces modes de réalisation soient indépendants, ces éléments sont identiques dans leur structure et leur fonctionnement, en sorte qu'il est inutile de les décrire à nouveau en détail dans leur application au mode de réalisation de la figure 5. On notera simplement que les données numériques obtenues par échantillonnage et conversion analogique/numérique du signal en bande de base J sont prises en compte pour la mise à jour de la première et/ou de la seconde table de pré-distorsion. Cette mise à jour peut-être réalisée selon tout algorithme adaptatif convenant à cet effet.

On appréciera que dans le mode de réalisation de la figure 4 comme dans celui de la figure 5, les moyens de pré-distorsion 40 peuvent ne comprendre que les moyens de pré-distorsion en phase 41 ou que les moyens de pré-distorsion en amplitude 42, ou peuvent comprendre à la fois les moyens de pré-distorsion en phase 41 et les moyens de pré-distorsion en amplitude 42. En effet, ces deux types de moyens sont indépendants dans leur structure comme dans leur fonction.

Dans un autre mode de réalisation, conforme à la figure 6, les moyens de génération GEN comprennent des moyens de pré-distorsion 40 incluant des moyens de pré-distorsion en phase 41 mais pas de moyens de pré-distorsion en amplitude. A la place, les moyens GEN comprennent en outre des moyens analogiques d'asservissement de l'amplitude du signal de sortie G à une consigne de modulation d'amplitude M générée à partir des valeurs numériques de la seconde suite de valeurs numériques C associées à la composante de modulation d'amplitude. Cette consigne M est un signal analogique obtenu au moyen d'un convertisseur numérique/analogique. Ces moyens analogiques d'asservissement comprennent un amplificateur COMP fonctionnant en intégrateur, dont une première entrée reçoit la consigne M, dont une seconde entrée reçoit un signal analogique L, et dont la sortie délivre le signal de commande de gain F qui est appliqué sur l'entrée de commande de gain de l'amplificateur PA. Ils comprennent en outre des moyens de couplage, qui peuvent être les moyens de couplage 400 des modes de réalisation des figures 3 et 5, délivrant le signal H image du signal de sortie G. Ils comprennent enfin un détecteur DET dont l'entrée reçoit le signal H et dont la sortie délivre le signal L. La fonction du détecteur DET est d'extraire du signal H la composante de modulation d'amplitude du signal de sortie G, en appliquant un redressement et un filtrage passe-bas au signal H de manière que l'amplitude en tension du signal L, classiquement exprimée en décibel (dBv), soit fonction de la puissance instantanée du signal H, classiquement exprimée en décibel (dBm). Le signal L est donc représentatif de la composante de modulation d'amplitude réellement présente dans le signal de sortie G. Le signal L et le signal M sont très proches l'un de l'autre, et ne diffèrent que par l'effet des non linéarités d'amplitude introduites dans le signal de sortie G par l'amplificateur PA. Le signal L est comparé par l'amplificateur intégrateur COMP à la consigne M, pour produire le signal de commande d'amplitude F en fonction de leur différence.

Comme on l'aura compris, les moyens analogiques d'asservissement de l'amplitude du signal de sortie G à la consigne de modulation d'amplitude M remplissent sensiblement la même fonction que les moyens de pré-distorsion en amplitude 42 des modes de réalisation de la figure 4 et de la figure 5, à savoir compenser les effets des non linéarités d'amplitude de l'amplificateur PA.

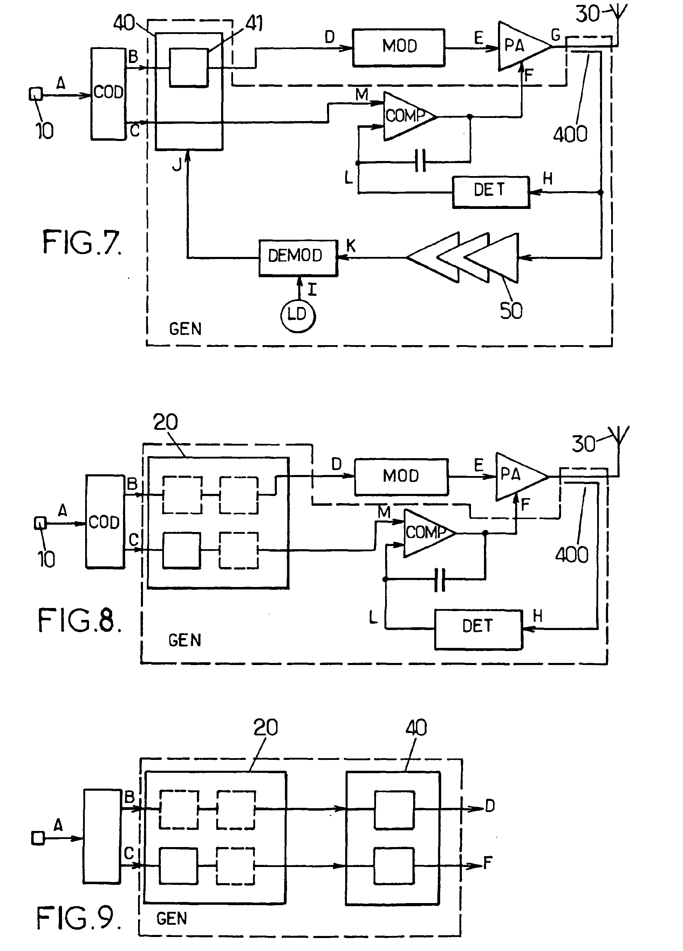

Dans un autre mode de réalisation, conforme au schéma de la figure 7, un dispositif selon l'invention se distingue de celui de la figure 6 en ce que les moyens de pré-distorsion en phase 41 sont agencés pour réaliser une pré-distorsion en phase adaptative, en fonction d'un signal en bande de base J obtenu à partir du signal de sortie G. A cet effet, le dispositif comprend les moyens précités formant voie de retour en bande de base, à savoir le dispositif de couplage 400, les moyens de démodulation DEMOD, et le cas échéant l'oscillateur local LO qui ont été présentés ci-dessus en référence au mode de réalisation de la figure 3. Toutefois, on notera que ces modes de réalisation sont indépendants. Les données numériques obtenues par échantillonnage et conversion analogique/numérique du signal en bande de base J sont prises en compte pour la mise à jour de la première table de pré-distorsion. Cette mise à jour peut-être réalisée selon tout algorithme adaptatif convenant à cet effet. L'avantage du mode de réalisation de la figure 7 réside dans le fait que, le signal en bande de base J n'étant pas utilisé pour compenser les effets des non linéarités d'amplitude de l'amplificateur PA, il n'est pas utile d'imposer de sévères contraintes de linéarité en amplitude à la voie de retour. De manière préférentielle mais non limitative, les moyens formant voie de retour en bande de base comprennent un limiteur 50 inséré entre les moyens de couplage 400 et les moyens de démodulation DEMOD. Ce limiteur reçoit le signal H sur une entrée et délivre un signal K sur sa sortie, qui est couplée à l'entrée des moyens de démodulation DEMOD. Ce signal K correspond au signal H débarrassé de la modulation d'amplitude. Dit autrement, le signal K est un signal d'amplitude constante, qui est l'image du signal de sortie G en termes de modulation de phase. Ceci permet de fournir en entrée des moyens de démodulation DEMOD un signal K d'amplitude constante, ce qui simplifie la réalisation pratique de ces moyens DEMOD.

Dans le mode de réalisation de la figure 8, le dispositif selon la figure 2 est complété par les moyens analogiques d'asservissement de l'amplitude du signal de sortie G à une consigne de modulation d'amplitude M générée à partir de la seconde suite de valeurs numériques C qui ont été présentés ci-dessus en référence au mode de réalisation de la figure 6.

Dans le mode de réalisation de la figure 9, les moyens de calage temporels 20 présentés ci-dessus en référence au mode de réalisation de la figure 2 sont combinés aux moyens 40 de pré-distorsion en phase et en amplitude présentés ci-dessus en référence au mode de réalisation de la figure 4. Ces deux types de moyens sont disposés en série, les moyens de calage temporel 20 étant en amont des moyens de prédistorsion en phase et en amplitude 40 comme montré à la figure ou vice versa.

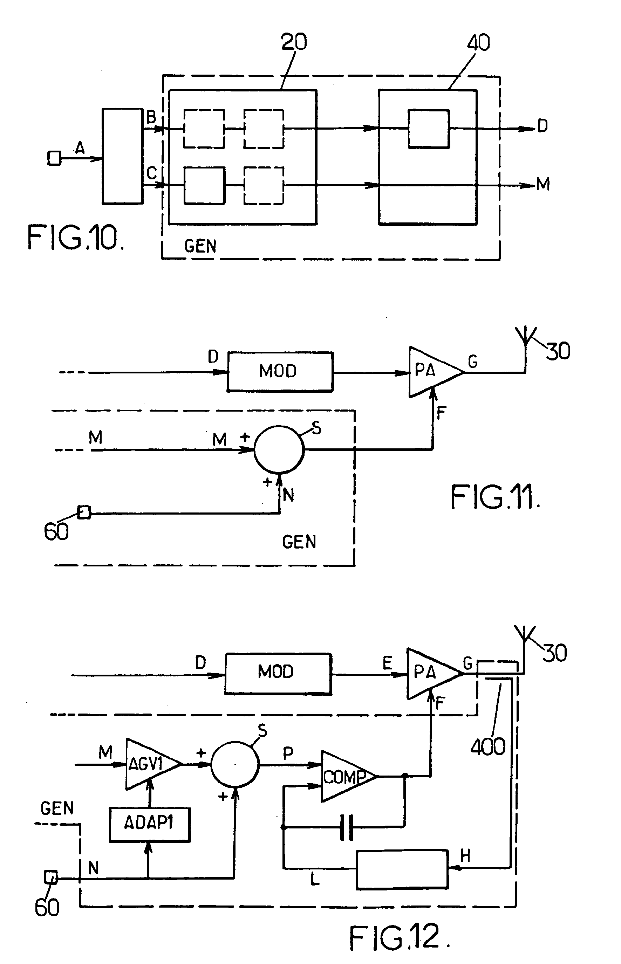

Dans le mode de réalisation de la figure 10, les moyens de calage temporels 20 présentés ci-dessus en regard de la figure 2 sont combinés aux moyens 40 de pré-distorsion en phase présentés ci-dessus en regard de la figure 6. Ces deux types de moyens sont disposés en série, les moyens de calage temporel 20 étant en amont des moyens de prédistorsion en phase 40 comme montré à la figure ou vice versa.

Dans certaines applications, le niveau de puissance moyen du signal de sortie G peut varier en fonction du mode de fonctionnement de l'émetteur incorporant le dispositif. En général, il varie par paliers entre un palier minimum par exemple égal à 21 dBm et un palier maximum par exemple égal à 33 dBm. Dans ce cas ce palier est commandé par la valeur de la composante continue du signal de commande d'amplitude F appliqué sur l'entrée de commande de gain de l'amplificateur PA, la composante alternative de ce signal constituant la consigne de modulation d'amplitude proprement dite. Or, les contraintes cumulées de précision du niveau de puissance moyen du signal de sortie G (par exemple +/- 3 dBm pour le palier de puissance le plus critique à savoir le palier de puissance minimum) et de précision de la modulation d'amplitude de ce signal (par exemple -60 dBv pour le palier minimum) imposent un codage par exemple sur au moins 13 bits des valeurs numériques du signal analogique F de commande d'amplitude (modes de réalisation des figures 1 à 5 et 9) ou du signal analogique M de consigne de modulation d'amplitude (modes de réalisation des figures 6 à 8 et 10) ayant une telle composante continue et une telle composante alternative. Selon un premier inconvénient, ceci implique l'emploi d'un convertisseur numérique/analogique fonctionnant sur 13 bits en entrée. Un tel convertisseur numérique/analogique est difficilement concevable dans un équipement tel qu'une station mobile de radiocommunications, pour des raisons tant de coût que d'intégration. Selon un second inconvénient, ceci implique pour le DSP la nécessité de traiter des données codées sur 13 bits, ce qui pénalise les performances du dispositif en termes de vitesse de calcul.

L'invention propose un mode de réalisation, conforme à la figure 11, permettant de pallier ces inconvénients. A la figure 11, un premier signal M analogique ne comportant que la composante de modulation d'amplitude (i.e., ayant une composante continue nulle), est généré au moyen d'un convertisseur numérique/analogique fonctionnant par exemple sur 11 bits en entrée. Un second signal analogique N est généré au moyen d'un autre convertisseur numérique/analogique fonctionnant par exemple sur 7 bits en entrée, ce signal N étant un signal continu dont la valeur commande la valeur du niveau moyen de puissance du signal de sortie G. Ainsi, le DSP ne traite que des données codées sur respectivement 11 et 7 bits au lieu de 13. En outre, il est plus avantageux d'utiliser deux convertisseurs numérique/analogique fonctionnant sur respectivement 11 et 7 bits en entrée qu'un seul fonctionnant sur 13 bits en entrée. Un circuit sommateur S reçoit le signal M sur une première entrée et le signal N sur une seconde entrée, et délivre sur sa sortie le signal de commande de modulation d'amplitude F résultant de la somme desdits signaux M et N. Le circuit sommateur S est un circuit analogique à base par exemple d'amplificateurs opérationnels. Comme dans les modes de réalisation précédents, le signal de commande de modulation d'amplitude F est porté sur l'entrée de commande de gain de l'amplificateur de puissance PA, et le signal de commande de modulation de phase D est porté sur l'entrée du modulateur MOD, dont la sortie est portée en entrée de l'amplificateur PA. La sortie de l'amplificateur PA est reliée à l'antenne 30 pour l'émission du signal de sortie G. Le dispositif comprend une entrée de niveau de puissance 60 pour recevoir le signal analogique N de commande du niveau moyen de la puissance du signal de sortie G. Cette entrée est reliée à la sortie d'un convertisseur numérique/analogique fonctionnant sur 7 bits en entrée (non représenté) couplé à une sortie du DSP (également non représenté).

Bien entendu, le mode de réalisation de la figure 11 peut avantageusement se combiner avec les moyens analogiques d'asservissement de l'amplitude du signal de sortie G à une consigne de modulation d'amplitude (modes de réalisation des figures 6 à 8). Toutefois, la pente de la caractéristique entrée / sortie du détecteur DET dépend de la valeur du niveau de puissance moyen du signal H c'est à dire en fait du niveau de puissance moyen du signal de sortie G . Le graphique de la figure 15 donne l'allure schématique de cette caractéristique. La valeur d'entrée du détecteur DET est constituée par le niveau puissance $P_H$ du signal H exprimée en dBm et portée sur l'axe des abscisses du graphique. La valeur de sortie du détecteur DET est constituée par le niveau de tension $V_L$ du signal L exprimé en dBv et porté sur l'axe des ordonnées. Comme indiqué par le graphique de la figure 15, la caractéristique entrée / sortie du détecteur DET comporte trois portions différentes P1, P2 et P3. Dans la portion P1, la plus proche de l'origine O, la pente de la caractéristique est nulle, ce qui traduit le fait que l'entrée se trouve en dessous du seuil de détection du détecteur. Dans la portion P2, la pente de la caractéristique évolue entre la valeur nulle et une valeur déterminée non nulle (qui vaut à peu près l'unité sur la figure 15). Enfin, dans la portion P3, la pente de la caractéristique est constante et vaut ladite valeur déterminée non nulle. Il en résulte que, pour obtenir une même modulation d'amplitude du signal de sortie G pour deux valeurs différentes du niveau de puissance moyen de ce signal, il peut être nécessaire de générer une consigne de modulation d'amplitude, c'est à dire une composante alternative du signal de commande d'amplitude F, qui dépend du niveau moyen de puissance du signal radiofréquence à émettre, c'est à dire de la composante continue du signal de commande d'amplitude F. Le phénomène décrit ci-dessus implique qu'un traitement supplémentaire des données numériques est requis. Ce traitement est un traitement numérique qui inclue des multiplications ou autres calculs supplémentaires en fonction de la valeur du signal N de commande du niveau moyen de la puissance du signal de sortie G, pour qu'il en soit tenu compte dans la production de la consigne de modulation d'amplitude M. Ce traitement numérique alourdit la charge de calcul du DSP. On notera d'ailleurs qu'un traitement numérique de même nature, bien que plus simple à mettre en oeuvre, serait également requis si le détecteur DET était utilisé dans des conditions de fonctionnement assurant le maintien dans la portion P3 de sa caractéristique qui est linéaire. En effet, il est de toutes façons nécessaire d'adapter la consigne de modulation d'amplitude M à la valeur du niveau de puissance moyen du signal de sortie résultant du signal N de commande du niveau moyen de puissance du signal de sortie G. On parle de "mise à l'échelle" pour désigner cette adaptation.

L'invention propose des modes de réalisation procurant une réponse analogique simple et efficace à ces problèmes, en évitant d'avoir à modifier par calcul numérique, suivant le niveau moyen de la puissance du signal radiofréquence à émettre tel qu'indiqué par la valeur du signal de commande N, la consigne de modulation d'amplitude M générée de façon numérique.

En effet, l'invention propose un mode de réalisation conforme à la figure 12 qui constitue une combinaison d'un des modes de réalisation des figures 6 à 10 d'une part et 11 d'autre part. Dans ce mode de réalisation, le dispositif inclue des moyens analogiques d'asservissement de l'amplitude du signal de sortie G à une consigne de modulation d'amplitude M. De plus, un amplificateur/atténuateur à gain variable AGV1 et un sommateur analogique S sont disposés entre la sortie des moyens de pré-distorsion 40 (modes de réalisation des figures 6,7,9 et 10) ou des moyens de calage temporels entre le signal de commande de phase et le signal de commande d'amplitude (mode de réalisation de la figure 8) d'une part, et la première entrée de l'amplificateur comparateur COMP d'autre part. Ainsi, l'entrée de l'amplificateur/atténuateur AGV1 reçoit la consigne de modulation d'amplitude M qui est alors de préférence purement alternative c'est à dire de composante continue nulle et indépendante du niveau de puissance moyen du signal de sortie G. La sortie de l'amplificateur/atténuateur AGV1 est reliée à une première entrée du sommateur S. Le dispositif comprend une entrée de niveau de puissance 60 pour recevoir un signal analogique N de commande du niveau moyen de la puissance du signal de sortie G. L'entrée 60 est reliée, d'une part à une seconde entrée du sommateur S, et d'autre part à une entrée de commande de gain de l'amplificateur/atténuateur AGV1, via éventuellement un circuit d'adaptation ADAP1, pour y délivrer le signal N. La sortie du sommateur S est reliée à la première entrée de l'amplificateur comparateur COMP pour y délivrer un signal P ayant pour composante continue le signal N et pour composante alternative le signal M multiplié par le gain de l'amplificateur/atténuateur AGV1. Le sommateur S a pour fonction d'additionner le signal N et la consigne de modulation de phase M pour produire le signal P. L'amplificateur/atténuateur AGV1 ainsi connecté, associé le cas échant au circuit d'adaptation ADAP1, a donc pour fonction d'adapter la composante alternative du signal de commande d'amplitude F au niveau de puissance moyen du signal de sortie G, sur la base d'une consigne de modulation d'amplitude M indépendante de ce niveau. Ceci est obtenu en commandant le gain de l'amplificateur/atténuateur AGV1 en fonction du signal N de commande du niveau moyen de puissance du signal de sortie G, de manière à compenser la variation de la pente de la caractéristique entrée / sortie du détecteur DET avec le niveau moyen de puissance dudit signal de sortie G d'une part, et à assurer la mise à l'échelle de la consigne de modulation d'amplitude M d'autre part. De cette manière, la consigne de modulation d'amplitude M générée par le DSP ne dépend pas de la valeur du signal N, c'est à dire du niveau moyen de la puissance du signal à émettre.

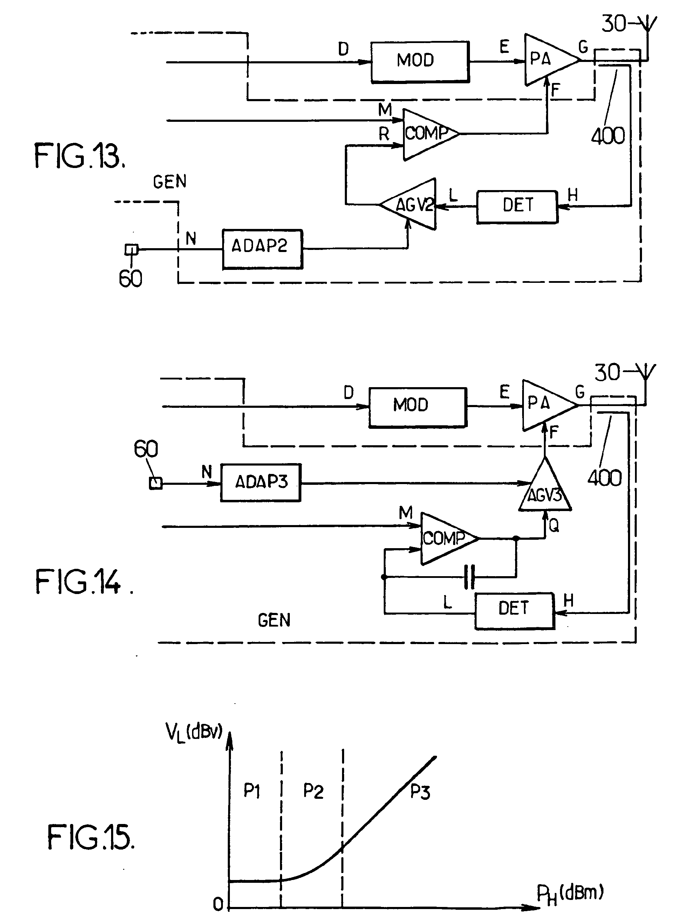

Dans une variante conforme au mode de réalisation de la figure 13, le dispositif comprend à la place de l'amplificateur/atténuateur AGV1 un amplificateur/atténuateur à gain variable AGV2 disposé en aval du détecteur DET. Plus exactement, l'entrée de l'amplificateur/atténuateur AGV2 est reliée à la sortie du détecteur DET de manière à recevoir le signal L délivré par ce détecteur. La sortie de l'amplificateur/atténuateur AGV2 est reliée à la seconde entrée de l'amplificateur comparateur COMP pour délivrer un signal R. Le signal R est le produit du signal L par le gain de l'amplificateur/atténuateur AGV2. L'entrée 60 du dispositif est reliée à une entrée de commande de gain de l'amplificateur/atténuateur AGV2, éventuellement via un circuit d'adaptation ADAP2, pour y délivrer le signal analogique N de commande du niveau de puissance moyen du signal de sortie G. Ainsi connecté, l'amplificateur/atténuateur AGV2, associé lé cas échéant au circuit d'adaptation ADAP2, a également pour fonction de rendre le signal analogique M indépendant du niveau de puissance moyen du signal de sortie G. Le niveau de puissance moyen du signal de sortie G est en effet déterminé par la valeur du signal R qui est la valeur de la tension L détectée par le détecteur DET multipliée par la valeur du gain de l'amplificateur/atténuateur AGV2. Le gain de cet amplificateur est commandé, le cas échéant grâce au circuit d'adaptation ADAP2, de manière à compenser la variation de la pente de la caractéristique entrée / sortie du détecteur DET avec le niveau moyen de puissance du signal de sortie G Dans cette variante, et au contraire du mode de réalisation de la figure 11, la consigne de modulation d'amplitude M comporte une composante alternative indépendante du niveau de puissance moyen du signal à émettre, et une composante continue constante qui détermine ce niveau. On notera que l'amplificateur/atténuateur AGV2 peut également être disposé en amont du détecteur DET. Dans ce cas (non représenté), son entrée est reliée aux moyens de couplage 400 pour recevoir le signal H et sa sortie est reliée à l'entrée du détecteur DET pour y délivrer le signal H multiplié par le gain de l'amplificateur/atténuateur AGV2, la sortie du détecteur DET étant reliée à la seconde entrée de l'amplificateur comparateur COMP comme sur les figures 6, 7 ou 8.

Les moyens analogiques d'asservissement de l'amplitude du signal de sortie G à la consigne de modulation d'amplitude M entraînent un déphasage entre la consigne de modulation d'amplitude M et la composante de modulation d'amplitude réellement présente dans le signal de sortie G. Ce déphasage dépend de la fréquence de la modulation d'amplitude. Classiquement, ce déphasage est linéaire pour les basses fréquences et peut être assimilé à un retard. La valeur de ce retard dépend de la fréquence de coupure du dispositif analogique d'asservissement en amplitude en boucle fermée. Plus cette fréquence de coupure est élevée, et plus le retard est faible. Or, la fonction de transfert du dispositif en boucle fermée n'est pas indépendante du niveau moyen de puissance du signal de sortie G. En effet, notamment, la pente de la caractéristique Tension de commande / Gain de l'amplificateur de puissance PA dépend de la composante continue du signal de commande d'amplitude F qu'il reçoit sur son entrée de commande de gain. Cette variation de pente entraîne une variation du gain du dispositif en boucle ouverte, d'où une variation de la fréquence de coupure du dispositif en boucle fermée, et donc une variation du retard précité. Cette variation du retard entre la consigne de modulation d'amplitude M et la composante de modulation d'amplitude réellement présente dans le signal de sortie G en fonction du niveau moyen de puissance du signal de sortie G est préjudiciable aux moyens de calage temporel du signal de commande de phase D et du signal de commande d'amplitude F.

Un moyen pour limiter la variation de la fréquence de coupure du dispositif en boucle fermée consiste à augmenter la fréquence de coupure du dispositif en boucle fermée. Toutefois, ceci peut nuire à la stabilité de la boucle d'asservissement en amplitude et se traduire par une augmentation du niveau de bruit dans le spectre du signal de sortie G. Un autre moyen consiste à augmenter le gain de l'amplificateur comparateur COMP. Toutefois, ceci peut également nuire à la stabilité de la boucle d'asservissement en amplitude et se traduire par une augmentation du niveau de bruit dans le spectre du signal de sortie G, et peut en outre se traduire par une augmentation de l'erreur de puissance dans le signal de sortie G en raison de l'offset résiduel en entrée de l'amplificateur comparateur COMP.

C'est pourquoi, dans un mode de réalisation conforme à la figure 14, le dispositif selon l'invention comporte un amplificateur/atténuateur à gain variable AGV3 disposé entre la sortie de l'amplificateur comparateur COMP et l'entrée de commande de gain de l'amplificateur de puissance PA. Plus exactement, l'entrée de l'amplificateur/atténuateur AGV3 est reliée à la sortie de l'amplificateur comparateur COMP. Ainsi le signal Q délivré par la sortie de l'amplificateur comparateur COMP est fourni en entrée de l'amplificateur AGV3. La sortie de l'amplificateur/atténuateur AGV3 est reliée à l'entrée de commande de gain de l'amplificateur de puissance PA pour délivrer le signal de commande d'amplitude F. L'entrée de niveau de puissance 60 est reliée à une entrée de commande de gain de l'amplificateur/atténuateur AGV3, éventuellement via un circuit d'adaptation ADAP3, pour y délivrer le signal analogique N de commande du niveau de puissance moyen du signal de sortie G qui est un signal indirectement représentatif de la pente de la caractéristique Tension de commande / Gain de l'amplificateur de puissance PA. La fonction de l'amplificateur/atténuateur AGV3 ainsi connecté, et associé le cas échéant au circuit d'adaptation ADAP3, est de compenser la variation, avec la valeur du niveau de puissance moyen du signal de sortie G, de la fréquence de coupure des moyens analogiques d'asservissement de l'amplitude du signal de sortie G à la consigne de modulation d'amplitude M . Ceci est obtenu en commandant le gain de l'amplificateur AGV3 en fonction dudit signal N de manière à compenser la variation, avec la valeur du niveau de puissance moyen du signal de sortie G, de la fréquence de coupure des moyens analogiques d'asservissement de l'amplitude du signal de sortie G à la consigne de modulation d'amplitude M. Dans ce mode de réalisation, la consigne de modulation d'amplitude M comporte une composante alternative et une composante continue constante qui détermine ce niveau.

On notera que les gains respectifs de l'amplificateur/atténuateur AGV1, AGV2 et/ou AGV3 peuvent être inférieurs à l'unité, ce qui revient à dire que chaque amplificateur/atténuateur peut introduire une amplification ou une atténuation.

Les modes de réalisation présentés ci-dessus en référence aux figures 2 à 14 se combinent bien en vue de la réalisation d'un dispositif de génération d'un signal radiofréquence modulé en phase et en amplitude présentant de bonnes performances dans diverses conditions de fonctionnement. Toutefois, on appréciera qu'ils peuvent également s'appliquer indépendamment les uns des autres, en fonction des objectifs requis et/ou des particularités de l'application du dispositif. Ceci est particulièrement vrai des modes de réalisations incluant des moyens 20 de calage temporel du signal de commande de phase et du signal de commande d'amplitude, de ceux incluant les moyens 40 de pré-distorsion adaptative en phase et/ou en amplitude, de ceux incluant les moyens d'asservissement de l'amplitude du signal de sortie à une consigne de modulation d'amplitude analogique M, de ceux incluant un sommateur analogique S pour ajouter un signal analogique de commande du niveau moyen de puissance du signal de sortie G à un signal analogique de consigne de modulation d'amplitude de ce signal G (figures 11, et 12), de ceux incluant l'amplificateur/atténuateur AGV1 (figure 12) ou l'amplificateur/atténuateur AGV2 (figure 13), et de ceux incluant l'amplificateur/atténuateur AGV3 (figure 14).

## Revendications

1. Dispositif de production d'un signal de sortie (G) radiofréquence modulé en phase et en amplitude convenant pour l'émission radioélectrique, comprenant :

   - au moins une entrée de données pour recevoir un message numérique (A) contenant des données à émettre ;
   - des moyens de codage composites (COD) pour générer, à partir dudit message numérique (A), une première suite de valeurs numériques (B) correspondant à une composante de modulation de phase du signal de sortie (G) et une seconde suite de valeurs numériques (C) correspondant à une composante de modulation d'amplitude du signal de sortie ;
   - des moyens de génération (GEN) d'un signal de commande de phase (D) et d'un signal de commande d'amplitude (F) à partir desdites premières (B) et secondes (C) suites de valeurs numériques,
   - des moyens de modulation de phase (MOD) dont une entrée reçoit le signal de commande de phase (D) et dont une sortie délivre un signal radiofréquence d'amplitude sensiblement constante modulé en phase (E) en fonction du signal de commande de phase (D) ; et
   - un amplificateur de puissance radiofréquence (PA) à gain variable, dont l'entrée est couplée à une sortie des moyens de modulation en phase (MOD) pour recevoir ledit signal radiofréquence d'amplitude sensiblement constante modulé en phase (E), dont une entrée de commande de gain reçoit le signal de commande d'amplitude (F), et dont une sortie délivre le signal de sortie (G),

   **caractérisé en ce que** lesdits moyens de génération (GEN) comprennent des moyens (20) de calage temporel du signal de commande de phase (D) et du signal de commande d'amplitude (F) de manière que la composante de modulation de phase soit synchronisée avec la composante de modulation d'amplitude dans le signal de sortie (G), lesdits moyens de calage temporel étant agencés pour réaliser un calage temporel du signal de commande de phase (D) et du signal de commande d'amplitude (F) en fonction d'un signal en bande de base (J) obtenu. à partir du signal de sortie (G).

2. Dispositif selon la revendication 1, **caractérisé en ce que** lesdits moyens de calage temporel comprennent au moins des premiers moyens numériques (21,22) pour appliquer un premier retard à la première suite de valeurs numériques (B) ou à la seconde suite de valeurs numériques (C).

3. Dispositif selon la revendication 2, **caractérisé en ce que** lesdits moyens de calage temporel comprennent en outre des seconds moyens numériques (23,24) pour appliquer un second retard, différent dudit premier retard, à l'autre suite de valeurs numériques (B,C).

**4.** Dispositif selon l'une des revendications 2 ou 3, **caractérisé en ce que** lesdits moyens numériques des moyens de calage temporel comprennent un premier registre à décalage (22) et/ou un second registre à décalage (21) par lesquels transitent, respectivement, la première (B) et/ou la seconde (C) suite de valeurs numériques à retarder.

**5.** Dispositif selon l'une des revendications 2 à 4, **caractérisé en ce que** lesdits moyens numériques des moyens de calage temporel comprennent un premier filtre numérique retardateur (24) et/ou un second filtre numérique retardateur (22) recevant en entrée, respectivement, la première suite de valeurs numériques (B) et/ou la seconde suite de valeurs numériques (C) à retarder, et délivrant en sortie, respectivement, ladite première et/ou ladite seconde suite de valeurs numériques retardées.

**6.** Dispositif selon la revendication 5, **caractérisé en ce que** le premier filtre numérique retardateur (24) et/ou le second filtre numérique retardateur (22) sont des filtres en sinus cardinal.

**7.** Dispositif selon la revendication 1, **caractérisé en ce qu'**il comprend un dispositif de couplage (400) pour prélever en sortie de l'amplificateur de puissance (PA) un signal (H) image du signal de sortie (G), un démodulateur (DEMOD) recevant sur une entrée ledit signal (H) image du signal de sortie (G) et délivrant sur une sortie ledit signal en bande de base (J) obtenu à partir du signal de sortie (G).

**8.** Dispositif selon l'une des revendications 1 à 7, **caractérisé en ce que** les moyens de génération (GEN) comprennent en outre des moyens numériques de pré-distorsion en phase (40) comportant une première table de valeurs (41) associant une valeur numérique pré-distordue à chaque valeur numérique de la première suite de valeurs numériques (B), le signal de commande de phase (D) étant généré en fonction de la suite desdites valeurs numériques pré-distordues de manière à annuler l'effet des non-linéarités en phase introduites dans le signal de sortie (G) par l'amplificateur de puissance (PA).

**9.** Dispositif selon l'une des revendications 1 à 8, **caractérisé en ce que** les moyens de génération comprennent en outre des moyens numériques de pré-distorsion en amplitude comportant une seconde table de valeurs (42) associant une valeur numérique pré-distordue à chaque valeur numérique de la seconde suite de valeurs numériques (C), le signal de commande d'amplitude (F) étant généré en fonction de la suite desdites valeurs numériques pré-distordues de manière à annuler l'effet des non-linéarités en amplitude introduites dans le signal de sortie (G) par l'amplificateur de puissance (PA).

**10.** Dispositif selon l'une des revendications 8 ou 9, **caractérisé en ce que** les moyens (40) de pré-distorsion en phase et/ou en amplitude sont agencés pour réaliser une pré-distorsion adaptative en fonction d'un signal en bande de base (J) obtenu à partir du signal de sortie (G).

**11.** Dispositif selon l'une des revendications 1 à 8, **caractérisé en ce** les moyens de génération (GEN) comprennent en outre des moyens analogiques d'asservissement de l'amplitude du signal de sortie (G) à une consigne de modulation d'amplitude (M) générée à partir de la seconde suite de valeurs numériques (C).

**12.** Dispositif selon la revendication 11, **caractérisé en ce que** lesdits moyens analogiques d'asservissement comprennent des moyens de couplage (400) délivrant un signal (H) image du signal de sortie (G), un détecteur (DET) dont une entrée reçoit le signal (H) image du signal de sortie (G) et dont la sortie délivre un signal (L) représentatif de la composante de modulation d'amplitude réellement présente dans le signal de sortie (G), un amplificateur comparateur (COMP), dont une première entrée reçoit la consigne de modulation, d'amplitude (M), dont une seconde entrée reçoit ledit signal (L) représentatif de la composante de modulation d'amplitude réellement présente dans le signal de sortie (G), et dont la sortie délivre le signal de commande de gain (F) qui est appliqué sur l'entrée de commande de gain de l'amplificateur de puissance (PA).

**13.** Dispositif selon l'une des revendications précédentes, **caractérisé en ce qu'**il comprend des moyens pour générer à partir de la seconde suite de valeurs numériques (C) un premier signal analogique (M) correspondant à une consigne de modulation d'amplitude, une entrée de niveau de puissance (60) pour recevoir un second signal analogique (N) de commande du niveau moyen de la puissance du signal de sortie (G), un circuit sommateur (S) recevant ledit premier signal analogique (M) sur une première entrée et ledit second signal analogique (N) sur une seconde entrée et délivrant sur une sortie le signal de commande de modulation d'amplitude (F) résultant de la somme desdits premiers (M) et second (N) signaux analogiques.

**14.** Dispositif selon l'une quelconque des revendications 11 à 13, **caractérisé en ce que**, le dispositif comprend une entrée de niveau de puissance (60) pour recevoir un signal analogique (N) de commande du niveau moyen de la puissance du signal de sortie (G), un premier amplificateur/atténuateur (AGV1) et un sommateur analogique (S), une entrée dudit premier amplificateur/atténuateur (AGV1) recevant la consigne de modulation d'amplitude (M), indépendante du niveau de puissance moyen du signal de sortie (G), et sa sortie étant reliée à une première entrée du sommateur (S), l'entrée de niveau de puissance (60) étant reliée d'une part à une seconde entrée du sommateur (S), et d'autre part à une entrée de commande de gain du premier amplificateur/atténuateur (AGV1) pour y délivrer le signal analogique (N) de commande du niveau moyen de la puissance du signal de sortie (G), la sortie du sommateur (S) étant reliée à la première entrée de l'amplificateur comparateur (COMP) pour délivrer un signal (P) ayant pour composante continue le signal analogique (N) de commande du niveau moyen de la puissance du signal de sortie (G) et pour composante alternative la consigne de modulation d'amplitude (M) multipliée par le gain du premier amplificateur/atténuateur (AGV1), le gain du premier amplificateur à gain variable (AGV1) étant commandé en fonction du signal analogique (N) de commande du niveau moyen de la puissance du signal de sortie (G) de manière à compenser la variation de la pente de la caractéristique entrée /sortie du détecteur (DET) avec le niveau moyen de puissance dudit signal de sortie (G) et à assurer la mise à l'échelle de la consigne de modulation d'amplitude (M).

15. Dispositif selon la revendication 14, **caractérisé en ce que** la composante continue de la consigne de modulation d'amplitude (M) est nulle.

16. Dispositif selon l'une des revendications 14 ou 15, **caractérisé en ce que** l'entrée de niveau de puissance (60) est reliée à l'entrée de commande de gain du premier amplificateur/atténuateur (AGV1) via un premier circuit d'adaptation (ADAP1) en sorte de commander le gain du premier amplificateur/atténuateur (AGV1) en fonction du signal (N) de commande du niveau moyen de la puissance du signal de sortie (G) de manière à compenser la variation de la pente de la caractéristique entrée / sortie du détecteur (DET) avec le niveau moyen de puissance dudit signal de sortie (G) et à assurer la mise à l'échelle de la consigne de modulation d'amplitude (M).

17. Dispositif selon l'une des revendications 11 à 16, **caractérisé en ce qu'**il comprend une entrée de niveau de puissance (60) pour recevoir un signal analogique (N) de commande du niveau moyen de la puissance du signal de sortie (G), ainsi qu'un deuxième amplificateur/atténuateur (AGV2) disposé en amont ou en aval du détecteur (DET), l'entrée de niveau de puissance (60) étant reliée à une entrée de commande de gain du deuxième amplificateur/atténuateur (AGV2) pour y délivrer le signal analogique (N) de commande du niveau moyen de la puissance du signal de sortie (G), le gain du second amplificateur à gain variable (AGV2) étant commandé en fonction du signal analogique (N) de commande du niveau moyen de la puissance du signal de sortie (G) de manière à compenser la variation de la pente de la caractéristique entrée / sortie du détecteur (DET) avec le niveau moyen de puissance dudit signal de sortie (G).

18. Dispositif selon la revendication 17, **caractérisé en ce que** l'entrée de niveau de puissance (60) est reliée à l'entrée de commande de gain du deuxième amplificateur/atténuateur (AGV2) via un deuxième circuit d'adaptation (ADAP2) permettant de commander le gain du deuxième amplificateur/atténuateur (AGV2) en fonction du signal (N) de commande du niveau moyen de la puissance du signal de sortie (G) de manière à compenser la variation de la pente de la caractéristique entrée / sortie du détecteur (DET) avec le niveau moyen de puissance du signal de sortie (G).

19. Dispositif selon l'une des revendications 11 à 18, **caractérisé en ce qu'**il comprend une entrée de niveau de puissance (60) pour recevoir un signal analogique (N) de commande du niveau moyen de la puissance du signal de sortie G, lesdits moyens de compensation comprennent un troisième amplificateur/atténuateur à gain variable (AGV3) dont l'entrée est reliée à la sortie de l'amplificateur comparateur (COMP) pour recevoir le signal (Q) délivré par la sortie de l'amplificateur comparateur (COMP), dont la sortie est reliée à l'entrée de commande de gain de l'amplificateur de puissance (PA) pour délivrer le signal de commande d'amplitude (F), l'entrée de niveau de puissance (60) étant reliée à une entrée de commande de gain du troisième amplificateur/atténuateur (AGV3) pour délivrer le signal (N) de commande du niveau de puissance moyen du signal de sortie G, le gain du troisième amplificateur à gain variable étant commandé en fonction dudit signal (N) de manière à compenser la variation, avec la valeur du niveau de puissance moyen du signal de sortie (G), de la fréquence de coupure des moyens analogiques d'asservissement de l'amplitude du signal de sortie (G) à la consigne de modulation d'amplitude (M).

20. Dispositif selon la revendication 19, **caractérisé en ce que** l'entrée de niveau de puissance (60) est reliée à l'entrée de commande de gain du troisième amplificateur/atténuateur (AGV3) via un troisième circuit d'adaptation (ADAP3) permettant de commander le gain de cet amplificateur/atténuateur (AGV3) de manière à compenser la variation, avec la valeur du niveau de puissance moyen du signal de sortie (G), de la fréquence de coupure des moyens analogiques d'asservissement de l'amplitude du signal de sortie (G) à la consigne de modulation d'amplitude (M).

**21.** Dispositif selon l'une quelconque des revendications précédentes, **caractérisé en ce que** les moyens de modulation de phase (MOD) comprennent un synthétiseur de modulation numérique.

**Claims**

**1.** A device for producing a phase and amplitude modulated radiofrequency output signal (G) suitable for radio transmission, comprising:

- at least one data input for receiving a digital message (A) containing data to be transmitted;
- composite means of coding (COD) for generating, on the basis of said digital message (A), a first string of digital values (B) corresponding to a phase modulation component of the output signal (G) and a second string of digital values (C) corresponding to an amplitude modulation component of the output signal;
- means (GEN) for generating a phase control signal (D) and an amplitude control signal (F) on the basis of said first (B) and second (C) strings of digital values,
- phase modulation means (MOD), an input of which receives the phase control signal (D) and an output of which delivers a radiofrequency signal of substantially constant amplitude and phase modulated (E) as a function of the phase control signal (D); and
- a variable-gain radiofrequency power amplifier (PA), the input of which is coupled to an output of the phase modulation means (MOD) so as to receive said phase modulated radiofrequency signal of substantially constant amplitude (E), a gain control input of which receives the amplitude control signal (F), and an output of which delivers the output signal (G),

**characterized in that** said generating means (GEN) comprise means (20) of temporal clamping of said phase control signal (D) and of the amplitude control signal (F) in such a way that the phase modulation component is synchronized with the amplitude modulation component in the output signal (G), said means of temporal clamping being designed to carry out a temporal clamping of the phase control signal (D) and of the amplitude control signal (F) as a function of a baseband signal (J) obtained on the basis of the output signal (G).

**2.** The device as claimed in claim 1, **characterized in that** said means of temporal clamping comprise at least first digital means (21, 22) for applying a first delay to the first string of digital values (B) or to the second string of digital values (C).

**3.** The device as claimed in claim 2, **characterized in that** said means of temporal clamping furthermore comprise a second digital means (23, 24) for applying a second delay, different from said first delay, to the other string of digital values (B, C).

**4.** The device as claimed in either of claims 2 and 3, **characterized in that** said digital means of the means of temporal clamping comprise a first shift register (22) and/or a second shift register (21) through which, respectively, the first (B) and/or the second (C) strings of digital values to be delayed travel.

**5.** The device as claimed in one of claims 2 to 4, **characterized in that** said digital means of the means of temporal clamping comprise a first delaying digital filter (24) and/or a second delaying digital filter (22) receiving as input, respectively, the first string of digital values (B) and/or the second string of digital values (C) to be delayed, and delivering as output, respectively, said first and/or second string of delayed digital values.

**6.** The device as claimed in claim 5, **characterized in that** the first delaying digital filter (24) and/or the second delaying digital filter (22) are sine cardinal filters.

**7.** The device as claimed in claim 1, **characterized in that** it comprises a coupling device (400) for picking up at the output of the power amplifier (PA) a signal (H) which is the image of the output signal (G), a demodulator (DEMOD) receiving on an input said signal (H) which is the image of the output signal (G) and delivering on an output said baseband signal (J) obtained on the basis of the output signal (G).

**8.** The device as claimed in one of claims 1 to 7, **characterized in that** the generating means (GEN) furthermore comprise digital means of phase predistortion (40) comprising a first table of values (41) associating a predistorted digital value with each digital value of the first string of digital values (B), the phase control signal (D) being generated as a function of the string of said predistorted digital values in such a way as to nullify the effect of the phase nonlinearities introduced into the output signal (G) by the power amplifier (PA).

9. The device as claimed in one of claims 1 to 8, **characterized in that** the generating means furthermore comprise digital means of amplitude predistortion comprising a second table of values (42) associating a predistorted digital value with each digital value of the second string of digital values (C), the amplitude control signal (F) being generated as a function of the string of said predistorted digital values in such a way as to nullify the effect of the amplitude nonlinearities introduced into the output signal (G) by the power amplifier (PA).

10. The device as claimed in either of claims 8 and 9, **characterized in that** the means (40) of phase and/or amplitude predistortion are designed to carry out an adaptive predistortion as a function of a baseband signal (J) obtained on the basis of the output signal (G).

11. The device as claimed in one of claims 1 to 8, **characterized in that** the generating means (GEN) further comprise analog means of servo control of the amplitude of the output signal (G) to an amplitude modulation pre-set (M) generated on the basis of the second string of digital values (C).

12. The device as claimed in claim 11, **characterized in that** said analog means of servo control comprise coupling means (400) delivering a signal (H) which is the image of the output signal (G), a detector (DET), an input of which receives the signal (H) which is the image of the output signal (G) and the output of which delivers a signal (L) representative of the amplitude modulation component actually present in the output signal (G), a comparator amplifier (COMP), a first input of which receives the amplitude modulation pre-set (M), a second input of which receives said signal (L) representative of the amplitude modulation component actually present in the output signal (G), and the output of which delivers the gain control signal (F) which is applied to the gain control input of the power amplifier (PA).

13. The device as claimed in one of the preceding claims, **characterized in that** it comprises means for generating on the basis of the second string of digital values (C) a first analog signal (M) corresponding to an amplitude modulation pre-set, a power level input (60) for receiving a second analog signal (N) for controlling the average level of the power of the output signal (G), a summator circuit (S) receiving said first analog signal (M) on a first input and said second analog signal (N) on a second input and delivering on an output the amplitude modulation control signal (F) resulting from the sum of said first (M) and second (N) analog signals.

14. The device as claimed in any one of claims 11 to 13, **characterized in that**, the device comprises a power level input (60) for receiving an analog signal (N) for controlling the average level of the power of the output signal (G), a first amplifier/attenuator (AGV1) and an analog summator (S), an input of said first amplifier/attenuator (AGV1) receiving the amplitude modulation pre-set (M), independent of the average power level of the output signal (G), and its output being linked to a first input of the summator (S), the power level input (60) being linked on the one hand to a second input of the summator (S), and on the other hand to a gain control input of the first amplifier/ attenuator (AGV1) so as to deliver thereto the analog signal (N) for controlling the average level of the power of the output signal (G), the output of the summator (S) being linked to the first input of the comparator amplifier (COMP) so as to deliver a signal (P) having as DC component the analog signal (N) for controlling the average level of the power of the output signal (G) and as AC component the amplitude modulation pre-set (M) multiplied by the gain of the first amplifier/attenuator (AGV1), the gain of the first variable-gain amplifier (AGV1) being controlled as a function of the analog signal (N) for controlling the average level of the power of the output signal (G) in such a way as to compensate for the variation in the slope of the input/output characteristic of the detector (DET) with the average power level of said output signal (G) and to ensure the scaling of the amplitude modulation pre-set (M).

15. The device as claimed in claim 14, **characterized in that** the DC component of the amplitude modulation pre-set (M) is zero.

16. The device as claimed in either of claims 14 and 15, **characterized in that** the power level input (60) is linked to the gain control input of the first amplifier/attenuator (AGV1) via a first adaptation circuit (ADAP1) so as to control the gain of the first amplifier/attenuator (AGV1) as a function of the signal (N) for controlling the average level of the power of the output signal (G) in such a way as to compensate for the variation in the slope of the input/output characteristic of the detector (DET) with the average power level of said output signal (G) and to ensure the scaling of the amplitude modulation pre-set (M).

17. The device as claimed in one of claims 11 to 16, **characterized in that** it comprises a power level input (60) for receiving an analog signal (N) for controlling the average level of the power of the output signal (G), as well as a second amplifier/attenuator (AGV2) arranged upstream or downstream of the detector (DET), the power level input (60) being linked to a gain control input of the second amplifier/attenuator (AGV2) so as to deliver thereto the analog signal (N) for controlling the average level of the power of the output signal (G), the gain of the second variable-gain amplifier (AGV2) being controlled as a function of the analog signal (N) for controlling the average level of the power of the output signal (G) in such a way as to compensate for the variation in the slope of the input/output characteristic of the detector (DET) with the average power level of said output signal (G).

18. The device as claimed in claim 17, **characterized in that** the power level input (60) is linked to the gain control input of the second amplifier/attenuator (AGV2) via a second adaptation circuit (ADAP2) making it possible to control the gain of the second amplifier/attenuator (AGV2) as a function of the signal (N) for controlling the average level of the power of the output signal (G) in such a way as to compensate for the variation in the slope of the input/output characteristic of the detector (DET) with the average power level of the output signal (G).

19. The device as claimed in one of claims 11 to 18, **characterized in that** it comprises a power level input (60) for receiving an analog signal (N) for controlling the average level of the power of the output signal G, said compensating means comprising a third variable-gain amplifier/attenuator (AGV3), the input of which is linked to the output of the comparator amplifier (COMP) so as to receive the signal (Q) delivered by the output of the comparator amplifier (COMP), the output of which is linked to the gain control input of the power amplifier (PA) so as to deliver the amplitude control signal (F), the power level input (60) being linked to a gain control input of the third amplifier/ attenuator (AGV3) so as to deliver the signal (N) for controlling the average power level of the output signal (G), the gain of the third variable-gain amplifier being controlled as a function of said signal (N) in such a way as to compensate for the variation, with the value of the average power level of the output signal (G), in the cutoff frequency of the analog means of servo control of the amplitude of the output signal (G) to the amplitude modulation pre-set (M).

20. The device as claimed in claim 19, **characterized in that** the power level input (60) is linked to the gain control input of the third amplifier/attenuator (AGV3) via a third adaptation circuit (ADAP3) making it possible to control the gain of this amplifier/attenuator (AGV3) in such a way as to compensate for the variation, with the value of the average power level of the output signal (G), in the cutoff frequency of the analog means of servo control of the amplitude of the output signal (G) to the amplitude modulation pre-set (M).

21. The device as claimed in any one of the preceding claims, **characterized in that** the phase modulation means (MOD) comprise a digital modulation synthesizer.

**Patentansprüche**

1. Vorrichtung zur Erzeugung eines Hochfrequenz-Ausgangssignales (G), das phasen- und amplitudenmoduliert ist, wobei diese geeignet ist für die Sendung von Radiofrequenzen, und wobei diese umfasst:

- mindestens eine Dateneingabe, um eine digitale Nachricht (A) zu empfangen, die zu sendende Daten umfasst;
- kombinierte Kodierungsmittel (COD), um ausgehend von besagter digitaler Nachricht (A) eine erste Abfolge von digitalen Werten (B) zu erzeugen, die einer Komponente der Phasenmodulation des Ausgangssignales (G) entspricht und eine zweite Abfolge von digitalen Werten (C), die einer Komponente der Amplitudenmodulation des Ausgangssignales entspricht;
- Erzeugungsmittel (GEN) eines Signales zur Phasensteuerung (D) und eines Signales zur Amplitudensteuerung (F), ausgehend von den genannten ersten (B) und zweiten (C) Abfolgen von digitalen Werten,
- Mittel zur Phasenmodulation (MOD), wobei eine Eingabe das Signal zur Phasensteuerung (D) empfängt und ein Ausgang ein Hochfrequenzsignal mit einer Amplitude ausgibt, die im Hinblick auf das Signal zur Phasensteuerung (D) deutlich konstant phasenmoduliert (E) ist; und
- Verstärker mit einer Hochfrequenzleistung (PA) mit variabler Verstärkung, dessen Eingabe mit einem Ausgang der Mittel der Phasenmodulation (MOD) verbunden ist, um besagtes Hochfrequenzsignal mit einer Amplitude, die deutlich konstant phasenmoduliert (E) ist, zu empfangen, wobei eine Eingabe zur Verstärkungssteuerung das Signal zur Steuerung der Amplitude (F) empfängt und wobei ein Ausgang das Ausgangssignal (G) ausgibt,

**gekennzeichnet dadurch, dass** die besagten Erzeugungsmittel (GEN) Mittel (20) zur zeitlichen Verschiebung des Signales zur Phasensteuerung (D) und des Signales zur Amplitudensteuerung (F) auf eine Weise umfassen, dass die Komponente der Phasenmodulation mit der Komponente der Amplitudenmodulation im Ausgangssignal (G) abgestimmt wird, wobei besagte Mittel zur zeitlichen Verschiebung so angeordnet sind, dass sie eine zeitliche Verschiebung des Signales zur Phasensteuerung (D) und des Signales zur Amplitudensteuerung (F) entsprechend einem Basisbandsignal (J) herstellen, das durch ein Ausgangssignal (G) erhalten wird.

2. Vorrichtung nach Anspruch 1, **gekennzeichnet dadurch, dass** besagte Mittel für die zeitliche Verschiebung mindestens erste digitale Mittel (21, 22) zur Anwendung einer ersten Verzögerung auf die erste Abfolge von digitalen Werten (B) oder auf die zweite Abfolge von digitalen Werten (C) umfassen.

3. Vorrichtung nach Anspruch 2, **gekennzeichnet dadurch, dass** besagte Mittel zur zeitlichen Verschiebung außerdem zweite digitale Mittel (23, 24) zur Anwendung einer zweiten Verzögerung auf die andere Abfolge von digitalen Werten (B, C) umfassen, wobei diese Verzögerung sich von der ersten besagten Verzögerung unterscheidet.

4. Vorrichtung nach einem der Ansprüche 2 oder 3, **gekennzeichnet dadurch, dass** die besagten digitalen Mittel der Mittel zur zeitlichen Verschiebung ein erstes Verschieberegister (22) und / oder ein zweites Verschieberegister (21) umfassen, durch welche die erste (B) und / oder die zweite (C) Abfolge von digitalen Werten veranlasst wird, sich zu verzögern.

5. Vorrichtung nach einem der Ansprüche 2 bis 4, **gekennzeichnet dadurch, dass** die besagten digitalen Mittel der Mittel zur zeitlichen Verschiebung einen ersten digitalen Verzögerungsfilter (24) und / oder einen zweiten digitalen Verzögerungsfilter (22) umfassen, welche an den Eingaben jeweils die erste Abfolge der zu verzögernden digitalen Werte (B) und /oder die zweite Abfolge der zu verzögernden digitalen Werte (C) empfangen und die besagte erste und / oder die besagte zweite Abfolge der verzögerten digitalen Werten an den Ausgang weitergeben.

6. Vorrichtung nach Anspruch 5, **gekennzeichnet dadurch, dass** der erste digitale Verzögerungsfilter (24) und /oder der zweite digitale Verzögerungsfilter (22) Filter mit einer Sinc-Funktion sind.

7. Vorrichtung nach Anspruch 1, **gekennzeichnet dadurch, dass** diese eine Schaltungsvorrichtung (400) umfasst, um am Ausgang des Leistungsverstärkers (PA) ein Bildsignal (H) des Ausgangssignales (G) auszugeben, wobei ein Demodulator (DEMOD) an einer Eingabe das besagte Bildsignal (H) des Ausgangssignales (G) empfängt und das besagte Basisbandsignal (J), das ausgehend vom Ausgangssignal (G) erhalten wurde, an einen Ausgang weitergibt.

8. Vorrichtung nach einem der Ansprüche 1 bis 7, **gekennzeichnet dadurch, dass** die Erzeugungsmittel (GEN) außerdem digitale Mittel zur Phasenvorverzerrung (40) umfassen, wobei diese eine erste Wertetabelle (41) umfassen, die einen vorverzerrten digitalen Wert mit jedem digitalen Wert der ersten Abfolge von digitalen Werten (B) in Bezug setzt, wobei das Signal zur Phasensteuerung (D) entsprechend der Abfolge der besagten vorverzerrten digitalen Werte auf eine Weise erzeugt wird, dass die Auswirkungen der phasengleichen Nichtlinearitäten, welche durch den Leistungsverstärker (PA) an das Ausgangssignal (G) weitergegeben werden, annuliert werden.

9. Vorrichtung nach einem der Ansprüche 1 bis 8, **gekennzeichnet dadurch, dass** die Erzeugungsmittel außerdem digitale Mittel zur amplitudengleichen Vorverzerrung umfassen, wobei diese eine zweite Wertetabelle (42) umfassen, die einen vorverzerrten digitalen Wert mit jedem digitalen Wert der zweiten Abfolge von digitalen Werten (C) in Bezug setzt, wobei das Signal zur Amplitudensteuerung (F) entsprechend der Abfolge der besagten vorverzerrten digitalen Werte auf eine Weise erzeugt wird, dass die Auswirkungen der amplitudengleichen Nichtlinearitäten, welche durch den Leistungsverstärker (PA) an das Ausgangssignal (G) weitergegeben werden, annuliert werden.

10. Vorrichtung nach einem der Ansprüche 8 oder 9, **gekennzeichnet dadurch, dass** die Mittel (40) der phasengleichen und / oder amplitudengleichen Vorverzerrung so angeordnet sind, dass sie eine Vorverzerrung zur Anpassung an ein Basisbandsignal (J) herstellen, welches durch das Ausgangssignal (G) erhalten wurde.

11. Vorrichtung nach einem der Ansprüche 1 bis 8, **gekennzeichnet dadurch, dass** die Erzeugungsmittel (GEN) außerdem analoge Mittel zur Nachlaufsteuerung der Amplitude des Ausgangssignales (G) mit einem Sollwert der Amplitudenmodulation (M) umfassen, wobei diese ausgehend von der zweiten Abfolge von digitalen Werten (C) erzeugt werden.

**12.** Vorrichtung nach Anspruch 11, **gekennzeichnet dadurch, dass** die besagten analogen Mittel zur Nachlaufsteuerung Mittel zur Kopplung (400) umfassen, die ein Bildsignal (H) des Ausgangssignales (G) ausgeben, sowie ein Detektorgerät (DET), bei dem eine Eingabe das Bildsignal (H) des Ausgangssignales (G) empfängt und dessen Ausgang ein Signal (L) ausgibt, welches für die Komponente der Amplitudenmodulation, die im Ausgangssignal (G) tatsächlich vorhanden ist, repräsentativ ist, sowie einen Vergleichsverstärker (COMP), bei dem eine erste Eingabe den Sollwert der Amplitudenmodulation (M) empfängt, und bei dem eine zweite Eingabe das besagte Signal (L) empfängt, welches für die Komponente der Amplitudenmodulation, die im Ausgangssignal (G) tatsächlich vorhanden ist, repräsentativ ist, und dessen Ausgang das Signal zur Verstärkungssteuerung (F) ausgibt, welches auf die Eingabe der Verstärkungssteuerung des Leistungsverstärkers (PA) angewendet wird.

**13.** Vorrichtung nach einem der vorangegangenen Ansprüche, **gekennzeichnet dadurch, dass** diese Mittel umfasst, um ausgehend von der zweiten Abfolge von digitalen Werten (C) ein erstes analoges Signal (M) zu erzeugen, das einem Sollwert der Amplitudenmodulation entspricht, eine Eingabe des Leistungspegels (60), um ein zweites analoges Steuerungssignal (N) des mittleren Leistungspegels des Ausgangssignales (G) zu empfangen, eine Summierschaltung (S), die besagtes erstes analoges Signal (M) an einer ersten Eingabe und besagtes zweites analoges Signal (N) an einer zweiten Eingabe empfängt und wobei das Steuerungssignal der Amplitudenmodulation (F), welches aus der Summe der besagten ersten (M) und zweiten (N) analogen Signale resultiert, an einem Ausgang ausgegeben wird.

**14.** Vorrichtung nach einem der Ansprüche 11 bis 13, **gekennzeichnet dadurch, dass** die Vorrichtung eine Eingabe des Leistungspegels (60) umfasst, um ein analoges Steuerungssignal (N) des mittleren Leistungspegels des Ausgangssignales (G) zu empfangen, sowie einen ersten Verstärker / ein erstes Dämpfungsglied (AGV1) und einen Analog-Summierer (S), wobei eine Eingabe des besagten ersten Verstärkers /Dämpfungsgliedes (AGV1) den Sollwert der Amplitudenmodulation (M) empfängt, der von dem mittleren Leistungspegel des Ausgangssignales (G) unabhängig ist und wobei dessen Ausgang mit einer ersten Eingabe einer zweiten Eingabe des Summierers (S) verbunden ist und auf der anderen Seite mit einer Eingabe der Verstärkungssteuerung des ersten Verstärkers / des ersten Dämpfungsgliedes (AGV1), um dort das analoge Steuerungssignal (N) des mittleren Leistungspegels des Ausgangssignales (G) auszugeben, wobei der Ausgang des Summierers (S) mit der ersten Eingabe des Vergleichsverstärkers (COMP) verbunden ist, um ein Signal (P) auszugeben, das als kontinuierliche Komponente das analoge Signal (N) der Ansteuerung des mittleren Leistungspegels des Ausgangssignales (G) und als alternative Komponente den Sollwert der Amplitudenmodulation (M) umfasst, der mit der Verstärkung des ersten Verstärkers / Dämpfungsgliedes (AGV1) multipliziert wird, wobei die Verstärkung des ersten Verstärkers mit variabler Verstärkung (AGV1) entsprechend dem analogen Steuerungssignal (N) der Steuerung des mittleren Leistungspegels des Ausgangssignales (G) so angesteuert wird, dass dieses die Neigungsveränderung des Eingangs- /Ausgangsmerkmales des Detektorgerätes (DET) durch das mittlere Leistungspegel des besagten Ausgangssignales (G) kompensiert und die Normierung des Sollwertes der Amplitudenmodulation (M) sicherstellt.

**15.** Vorrichtung nach Anspruch 14, **gekennzeichnet dadurch, dass** die kontinuierliche Komponente des Sollwertes der Amplitudenmodulation (M) gleich Null ist.

**16.** Vorrichtung nach einem der Ansprüche 14 oder 15, **gekennzeichnet dadurch, dass** die Eingabe des Leistungspegels (60) mit der Eingabe der Verstärkungssteuerung des ersten Verstärkers /Dämpfungsgliedes (AGV1) über eine erste Anpassungsschaltung (ADAP1) verbunden ist, so dass die Verstärkung des ersten Verstärkers / Dämpfungsgliedes (AGV1) entsprechend dem Steuerungssignal (N) des mittleren Leistungspegels des Ausgangssignales (G) angesteuert wird, um die Neigungsveränderung des Eingangs- / Ausgangsmerkmales des Detektorgerätes (DET) anhand des mittleren Leistungspegels des besagten Ausgangssignales (G) zu kompensieren und die Normierung der Amplitudenmodulation (M) sicherzustellen.

**17.** Vorrichtung nach einem der Ansprüche 11 bis 16, **gekennzeichnet dadurch, dass** diese eine Eingabe des Leistungspegels (60) umfasst, um ein analoges Steuerungssignal (N) des mittleren Leistungspegels des Ausgangssignales (G) zu empfangen, sowie einen zweiten Verstärker / ein zweites Dämpfungsglied (AGV2), das dem Detektorgerät (DET) vorgelagert oder nachgelagert ist, wobei die Eingabe des Leistungspegels (60) mit einer Eingabe der Verstärkungssteuerung des zweiten Verstärkers / Dämpfungsgliedes (AGV2) verbunden ist, um dort das analoge Steuerungssignal (N) des mittleren Leistungspegels des Ausgangssignales (G) auszugeben, wobei die Verstärkung des zweiten Verstärkers mit einer variablen Verstärkung (AGV2) entsprechend dem analogen Steuerungssignal (N) des mittleren Leistungspegels des Ausgangssignales (G) angesteuert wird, um die Neigungsveränderung des Eingangs- / Ausgangsmerkmales des Detektorgerätes (DET) durch den mittleren Leistungspegel des besagten Ausgangssignales (G) zu kompensieren.

**18.** Vorrichtung nach Anspruch 17, **gekennzeichnet dadurch, dass** die Eingabe des Leistungspegels (60) mit der Eingabe der Verstärkungssteuerung des zweiten Verstärkers / Dämpfungsgliedes (AGV2) über eine zweite Anpassungsschaltung (ADAP2) verbunden ist, wodurch die Verstärkungssteuerung des zweiten Verstärkers /Dämpfungsgliedes (AGV2) entsprechend dem Steuerungssignal (N) des mittleren Leistungspegels des Ausgangssignales (G) ermöglicht wird, so dass die Neigungsveränderung des Eingangs- / Ausgangsmerkmales des Detektorgerätes (DET) mittels des mittleren Leistungspegels des Ausgangssignales (G) kompensiert wird.

**19.** Vorrichtung nach einem der Ansprüche 11 bis 18, **gekennzeichnet dadurch, dass** diese eine Eingabe des Leistungspegels (60) umfasst, um ein analoges Steuerungssignal (N) des mittleren Leistungspegels des Ausgangssignales (G) zu empfangen, wobei besagte Mittel zur Kompensierung einen dritten Verstärker / ein drittes Dämpfungsglied mit variabler Verstärkung (ABF3) umfassen, dessen Eingabe mit dem Ausgang des Vergleichsverstärkers (COMP) verbunden ist, um das Signal (Q) zu empfangen, das durch den Ausgang des Vergleichsverstärkers (COMP) ausgegeben wird, dessen Ausgang mit der Eingabe der Verstärkungssteuerung des Leistungsverstärkers (PA) verbunden ist, um das Steuerungssignal der Amplitude (F) auszugeben, wobei die Eingabe des Leistungspegels (60) mit einer Eingabe der Verstärkungssteuerung des dritten Verstärkers / des dritten Dämpfungsgliedes (AGV3) verbunden ist, um das Steuerungssignal (N) des mittleren Leistungspegels des Ausgangssignales (G) auszugeben, wobei die Verstärkung des dritten Verstärkers mit variabler Verstärkung entsprechend dem besagten Signal (N) so gesteuert wird, dass die Veränderung durch den Wert des mittleren Leistungspegels des Ausgangssignales (G) der Frequenzunterbrechung der analogen Mittel zur Nachlaufsteuerung der Amplitude des Ausgangssignales (G) anhand des Sollwertes der Amplitudenmodulation (M) kompensiert wird.

**20.** Vorrichtung nach Anspruch 19, **gekennzeichnet dadurch, dass** die Eingabe des Leistungspegels (60) mit der Eingabe der Verstärkungssteuerung des dritten Verstärkers / des dritten Dämpfungsgliedes (AGV3) über eine dritte Anpassungsschaltung (ADAP3) verbunden ist, welche die Verstärkungssteuerung dieses Verstärkers /Dämpfungsgliedes (AGV3) derart gestattet, dass die Veränderung durch den Wert des mittleren Leistungspegels des Ausgangsignales (G) der Unterbrechungsfrequenz der analogen Mittel der Nachlaufsteuerung der Amplitude des Ausgangssignales (G) durch den Sollwert der Amplitudenmodulation (M) kompensiert wird.

**21.** Vorrichtung nach einem beliebigen der vorangegangenen Ansprüche, **gekennzeichnet dadurch, dass** die Mittel der Phasenmodulation (MOD) einen digitalen Modulationsgenerator umfassen.

FIG.1.

FIG.2.

FIG.3.

FIG.4.

FIG.5.

FIG.6.

FIG.7.

FIG.8.

FIG.9.

**FIG.10.**

**FIG.11.**

**FIG.12.**

FIG.13.

FIG.14.

FIG.15.